Europäisches Patentamt

European Patent Office

Office européen des brevets

(11) Veröffentlichungsnummer: **0 315 905**
**A2**

(12) **EUROPÄISCHE PATENTANMELDUNG**

(21) Anmeldenummer: 88118370.1

(22) Anmeldetag: 04.11.88

(51) Int. Cl.4: **H01L 33/00 , H01L 25/04 ,**
**H05K 1/18**

(30) Priorität: 07.11.87 DE 3737861

(43) Veröffentlichungstag der Anmeldung:
17.05.89 Patentblatt 89/20

(84) Benannte Vertragsstaaten:
CH DE FR GB IT LI

(71) Anmelder: Müller, Werner
Ellerhöhweg 9B
D-6380 Bad Homburg(DE)

(72) Erfinder: Müller, Werner
Ellerhöhweg 9B
D-6380 Bad Homburg(DE)

(54) Elektronisches Leuchtelement.

(57) Es wird ein elektronisches Leuchtelement beschrieben umfassend einen Glühlampensockel, ein Übergangselement, eine Leiterplatte, welche keramisches Material enthält und wenigstens einen Leuchtdiodenchip, welcher auf der Leiterplatte innerhalb einer Epoxiharzmasse angeordnet ist.

Dsa elektronische Leuchtelement zeichnet sich dadurch aus, daß es in beleuchtbaren Befehlsgeräten und Meldeleuchten, welche im allgemeinen die Schnittstelle zwischen Mensch und Maschine bilden, als Ersatz für Kleinglühlampen eingesetzt werden kann, ohne jedoch die bekannten Nachteile herkömmlich verwendeter Kleinglühlampen aufzuweisen.
Es wird ein Verfahren zur Herstellung eines derartigen Leuchtelementes beschrieben. Das Verfahren beruht darauf, daß duch ein modifiziertes, stark thixotropes Epoxiharz das Umhüllen der Leuchtdiode auf der Leiterplatte ohne formgebendes Werkzeug ermöglicht wird.

EP 0 315 905 A2

# ELEKTRONISCHES LEUCHTELEMENT MIT OPTIMIERTER LICHTAUSBEUTE VERFAHREN ZU SEINER HERSTELLUNG

Die vorliegende Erfindung betrifft ein elektronisches Leuchtelement umfassend einen Sockel, ein Übergangselement, eine Leiterplatte und wenigstens eine, im allgemeinen mehrere Leuchtdiodenchips. Die Erfindung betrifft ferner ein Verfahren zur Herstellung eines derartigen Leuchtelementes.

Leuchtelemente ähnlicher Art sind bereits bekannt und werden üblicherweise in Leuchtmeldern, Leuchttastern und/oder Leuchtschaltern eingesetzt. Die Leuchtdioden haben gegenüber herkömmlichen Kleinglühlampen den Vorteil einer wesentlich höheren Lebensdauer, insbesondere unter hoher mechanischer Belastung durch Erschütterungen. Neben diesen beträchtlichen Vorteilen ist jedoch ihre Lichtausbeute, speziell die gleichmäßige Lichtverteilung immer noch verbesserungswürdig.

Die Aufgabe der Erfindung bestand darin, ein Diodenleuchtelement zu schaffen, das einerseits eine ausreichende und gleichmäßige Ausleuchtung von Abdeckhauben und Abdeckkappen von beleuchtbaren Befehsgeräten und Meldeleuchten gewährleistet, das aber andererseits bei dem bestimmungsgemäßen Betrieb der nebeneinander auf der Leiterplatte angeordneten Bauelemente auftretende Wärmeentwicklung optimal ableiten kann. Dieses elektronische Leuchtelement soll darüber hinaus ohne großen Aufwand in ein beleuchtbares Befehlsgerät oder Meldeleuchte entsprechend einer Kleinglühlampe auswechselbar sein und schließlich unter kommerziellen Bedingungen einfach und preiswert in großen Stückzahlen produzierbar sein.

Gelöst wird diese Aufgabe durch ein elektronisches Leuchtelement der eingangs genannten Gattung, dessen kennzeichnende Merkmale darin zu sehen sind, daß die Leiterplatte keramisches Material enthält und daß wenigstens eine Leuchtdiode auf der Leiterplatte innerhalb einer Epoxiharzmasse angeordnet ist.

Der Glühlampensocke besteht im allgemeinen aus einem länglichen, einsteckbaren, zylindrischen Körper aus formstabilem Material, der im wesentlichen zwei elektrische Kontakte umfaßt, und das Leuchtelement zwar ortsfest, jedoch einer Glühlampe entsprechend, auch auswechselbar im Gehäuse fixiert,beziehungsweise festhält. Das Übergangselement dient dazu, den Sockel und die Leiterplatte zu verbinden. Es besteht aus elektrisch isolierendem Material, vorzugsweise aus Kunststoff, besonders bevorlzugt aus wärmefestem Kunststoff. Das Übergangselement weist eine zylindrische Formauf und kann in seinem Inneren hohl oder ausgegossen sein. Das Übergangselement ist auf der einen Seite durch einen Flansch, der einen Durchmesser aufweist, der dem Außendurchmesser des Glaskolbens einer Glühlampe entspricht und durch eine geeignete Klebeverbindung mit dem Sockel verbunden ist. Auf der anderen Seite grenzt es an die Leiterplatte und ist an dieser ebenfalls durch eine Klebeverbindung befestigt. Das Übergangselement soll die Leiterplatte in standardmäßigen Leuchttastern, Leuchtmeldern und Leuchtschaltern in einem geeigneten Abstand zu der Tastenkappe festhalten.

Die Leiterplatte ist im wesentlichen ein flächenhaftes Element von rechteckiger Form. Auf der Leiterplatte sind Leiterbahnen aus elektrisch leitfähigem Material bevorzugt Metall aufgebracht, insbesondere aufgedruckt. Als Metall wird eine Silber-Palladium Legierung eingesetzt, weil diese sich als Paste besonders günstig im Siebdruckverfahren auf das keramische Material aufdrucken läßt und anschließend eingebrannt werden kann. Diese Legierung besitzt vorteilhafterweise eine Wärmeausdehnungskoeffizienten, der dem keramischen Grundmaterial angepaßt ist.

Die Leiterbahnen verbinden die elektrischen Kontakte aus dem Sockel mit den elektronischen Bauelementen. Als elektrische und elektronische Bauelemente werden im allgemeinen Widerstände, Dioden und/oder den elektrischen Strom regulierende Bauelemente vorgesehen.

Als aktive Bauelemente werden bevorzugt ungehäuste Halbleiter eingesetzt, die gemäß dem Chip-und Wire-Verfahren auf der Leiterplatte befestigt und elektrisch kontaktiert werden. Passive Bauelemente können falls benötigt bevorzugt in einem rationellen Siebdruckverfahren auf die Leiterplatte aufgebracht werden. Erfindungsgemäß besteht die Leiterplatte aus keramischem Material. Unter keramischem Material werden im allgemeinen anorganische Metalloxide wie Aluminiumoxid, Aluminiumnitrit, Magnesiumoxid oder Berylliumoxid verstanden. Erfindungsgemäß bevorzugt wird Aluminiumoxid eingesetzt. Die Dicke der Leiterplatte liegt im Bereich von 0,1 - 1,5 mm, vorzugsweise 0,3 - 1,0 mm. Unter einer leuchtdiode versteht man ein Halbleiterelement, das bei einem Stromdurchfluß in einer bestimmten Richtung sichtbares Licht erzeugt. Derartige Leuchtdioden haben den großen Vorteil, daß sie relativ wenig Platz benötigen und verglichen mit herkömmlichen Glühlämpchen eine um das Vielfache erhöhte Lebensdauer aufweisen. Sie sind ferner gegen mechanische Erschütterungen unempfindlich und erzeugen beim Einschalten keinen Stromstoß, welcher bei elelktrischen Glühlampen bis zum 10fachen des Nennstroms betragen kann. Ein weiterer Vorteil von derartigen Leuchtdioden besteht in Hinsicht auf das Alterungsverhalten. Während bei gebräuchlichen Glühlampen die Lichtemission am Ende der Lebensdauer spontan durch Bruch der Glühwendel erlischt, nimmt bei Leuchtdioden die Lichtemission kontinuierlich über einen längeren Zeitraum ab. Es werden Halbwertzeiten von 10 bis 100 Jahren erreicht.

Zum Schutz vor mechanischen und chemischen Einflüssen der Diode und des Bonddrahtes und zur Vergrößerung des Grenzwinkels des austretenden Lichtes ist erfindungsgemäß die Leuchtdiode innerhalb einer Epoxiharzmasse angeordnet. Die Epoxiharzmasse besitzt erfindungsgemäß die Form eines runden oder rotationssymmetrischen, nach oben, d.h. von der auf der Leiterplatte montierten Leuchtdiode weg, linsenförmig gewölbten Domes.

Unter einem nach oben linsenförmig gewölbten Dom soll im Rahmen der Erfindung ein geometrischer Körper verstanden werden, der ähnlich einer Halbkugel mit einer rotationssymmetrischen Fläche auf der ebenen Leiterplatte haftet, und sich nach oben, von der Leiterplatte weg, in runder oder nicht unbedingt regelmäßiger Form erhebt. Vergleichbar ist ein solcher Dom beispielsweise mit einem umgekehrten Rotstionsparaboloid oder einem Segment eines Rotationsellipsoides.

Das Verhältnis des Durchmessers der Grundfläche des rotationssymmetrischen Domes zu seiner Höhe, gemessen von der mit der Leiterplatte anschließenden Grundfläche, bis zu seinem von der Leiterplatte am weitesten entfernten Punkt, liegt erfindungsgemäß im Bereich von verhältnismäßig 0.5 bis 5 bevorzugt 1 bis 3 . Wenn mit dem erfindungsgemäßen Leuchtelement flächenhafte Bereiche ausgeleuchtet werden sollen, können vorzugsweise mehrere Leuchtdioden auf einer Leiterplatte angeordnet sein, wobei jeweils eine Leuchtdiode in jeweils einem Dom der Epoxiharzmasse wie bereits beschrieben angeordnet ist.

Das Epoxiharz, das im Rahmen der Erfindung eingesetzt wird, ist ein duroplastischer Harz, d.h. ein Harz, das im zähflüssigen Zustand aufgebracht wird und dann einer irreversibelen Härtung unterzogen wird. Epoxiharze bestehen üblicherweise aus einer ersten Komponente enthaltend Epoxigruppen im Molekül, und einer zweiten Komponente enthaltend Gruppen, die befähigt sind, mit den Epoxigruppen eine chemische Reakton einzugehen und dadurch eine Vernetzung zu bewirken.

Erfindungsgemäß soll aus der Menge der bekannten Epoxiharze ein solches ausgewählt werden, das sich durch eine möglichst große Wärmebeständigkeit auszeichnet, worunter zu verstehen ist , daß es bei längerer Wärmeeinwirkung, wie z.B. beim bestimmungsgemäßen Betrieb des Leuchtauftritt, nicht durch Zersetzungsprodukte verfärbt wird und insbesondere seine Transparenz beibehält.

Epoxiharze die diese Bedingungen erfüllen sind beispielsweise solche, die durch Anhydridgruppen enthaltende Härter oder Vernetzerkomponenten hergestellt sind. Die Epoxiharze sind nach Aushärtung, üblicherweise gut transparent, besitzen eine faltenfreie glatte Oberfläche und weisen einen Brechungsindex im Bereich von 1.5 bis 1.6 auf.

Die Erfindung betrifft auch ein Verfahren zur Herstellung eines Leuchtelementes wie vorstehend beschrieben. Das Verfahren besteht darin, daß eine oder mehrere ungehäuste Leuchtdioden auf einer keramischen Leiterplatte und den darauf bereits angeordneten Leiterbahnen nach dem Chip-und-Wire-Verfahren aufgebracht werden, daß dann ein härtbares Epoxiharz enthaltend zusätzlich ein Thixotropierungsmittel auf die Leuchtdiode aufgebracht wird und daß am Schluß das Epoxiharz zuerst angehärtet und dann ausgehärtet wird. Das aufbringen der Leuchtdiode nach dem Chip-und-Wire-Verfahren ist stand derTechnik und braucht im Rahmen der Offenbarung der Erfindung nicht näher beschrieben zu werden. Als Thixotropierungsmittel eignen sich im allgemeinen anorganische Verbindungen wie Bentonite, Kaoline, Asbest, besonders die Verbindung auf der Basis von Kieselsäure. Die Thixotropierungsmittel können einzeln oder in Kombination in einer Menge im Bereich von 2 bis 10 gew.-% in dem Epoxiharz und dem Härter vermischt werden, wobei sich die Prozentangabe auf das gesamtgewicht der Mischung bezieht. Die bevorzugte Menge der Thixotropierungsmittel beträgt 4 bis 10 gew.-%. Das Thixotropierungsmittel wird durch Rühren in dem zähflüssigen Epoxiharz vermischt, bevorzugt durch Rühren unter leichtem Unterdruck (Vakuum ). Vorzugsweise wird das Epoxiharz nach dem Vermischen mit dem Thixotropierungsmittel und vor dem Aufbringen auf der Leuchtdiode einem Trocknungsprozess unterworfen.

Erfindungsgemäß wird die fertige Mischung aus Epoxiharz, Härter und Thixotropierungsmittel auf die Leuchtdiode aufgebracht, indem sie von oben durch eine Kanüle (Dispenser) aufgetropft oder aufextrudiert wird. Nach dem Aufbringen der Epoxiharzmischung auf die Leuchtdiode wird diese einem mehrere Stunden dauernden Anhärtungsprozess unterworfen. Die Anhärtung wird vorzugsweise bei leichtem Unterdruck und in Anwesenheit eines geeigneten Trocknungsmittel durchgeführt. Ein geeignetes Trocknungsmittel ist z.B. Kiesgel. Zweckmäßigerweise wird die Anhärtung bei leicht erhöhten Temperaturen im Bereich von 25° bis 50° und über eine Zeitspanne von einem bis etwa drei Tagen durchgeführt. Das Harz überdeckt zweckmäßigerweise die Leuchtdiode und den Bonddraht vollständig und es erstreckt sich dabei auf die Bereiche der Leiterplatte, die sich in unmittelbarer Nähe der Leuchtdiode befindet.

Da das Harz sehr große thixotrope Eigenschaften aufweist, wird erfindungsgemäß kein Fertigungswerkzeug benötigt, um das Harz in der gewünschten Form zu halten. Das Harz behält nach dem erfindungsgemäßen Verfahren die vor der Aushärtung reine Tropfenform bei, ohne auf der Leiterplatte auseinanderzufließen.

Der letzte Fertigungsschritt zur Einkapselung der Leuchtdioden ist die Aushärtung des Epoxidomes. Dies wird erfindungsgemäß in einem Ofen bei Temperaturen im Bereich von 60° bis 120° durchgeführt.

Erfindungsgemäß wird das Leuchtelement verwendet in Leuchtschaltern,Leuchttastern und Leuchtmeldern. Üblicherweise wird bei derartigen Befehlsgeräten durch ein optisches Signal bezw. durch das Aufleuchten der Abdeckhaube oder der Tastenkappe der Schaltzustand angezeigt.

Der Hauptvorteil der Erfindung liegt in der sehr langen Lebensdauer des erfindungsgemäßen Leuchtelements, daß jedoch eine mit Glühlampen vergleichbare Ausleuchtung und Helligkeit dieser Befehlsgeräte ermöglicht und entsprechend herkömmlicher Glühlampen ohne großen Aufwand in diese Befehlsgeräte eingesetzt werden kann, ohne die bekannten Nachteile von Glühlampen nachzuweisen.

Die Erfindung wird an Hand der beigefügten beispielhaften Zeichnungen näher erläutert, ohne sich auf diese konkrete Ausführungsform zu beschränken.

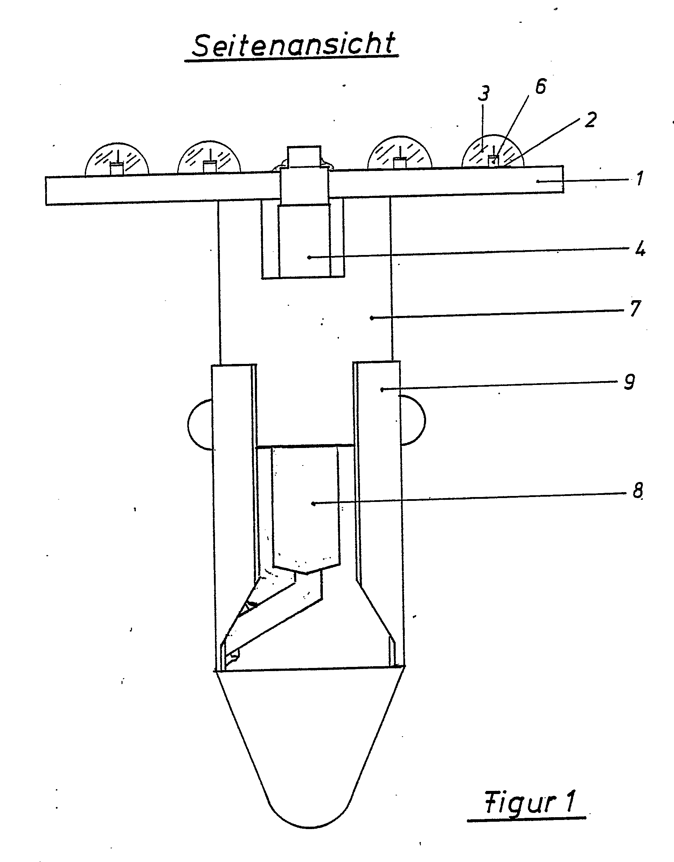

Figur 1 zeigt ein erfindungsgemäßes Leuchtelement in seitlicher Ansicht.

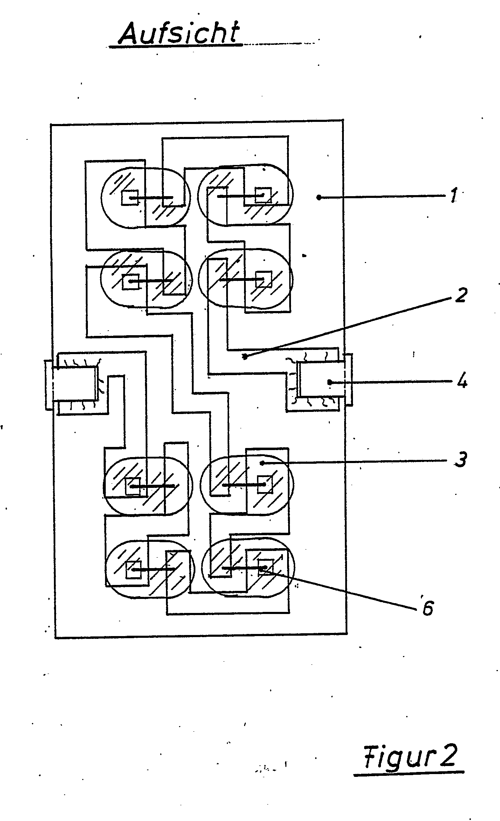

Figure 2 zeigt ein erfindungsgemäßes Leuchtelement in senkrechter Aufsicht.

Durch Bezugsziffern sind hervorzuheben (1) das Substrat aus Keramik, die Leiterbahnen (2), der Epoxidom (3), die Anschlußklammern (4), durch welche die Leiterbahnen mit dem Sockel verbunden sind. Der Leuchtdiodenchip, der mit dem Bonddraht (6) die elektrische Kontaktierung zum folgenden Leiterbahnabschnitt darstellt. Das Übergangselement (7) verbindet die Keramikplatte mit dem Sockel (9). Der Vorwiderstand (8) stellt in einfachster Ausführung eine Stromregelung dar.

**Ansprüche**

1. Elektronisches Leuchtelement umfassend einen Sockel, ein Übergangselement, eine Leiterplatte und wenigstens eine Leuchtdiode, dadurch gekennzeichnet, daß die Leiterplatte keramisches Material enthält und daß wenigstens eine Diode auf der Leiterplatte und innerhalb einer Epoxiharzmasse angeordnet ist.

2. Leuchtelement nach Anspruch 1, dadurch gekennzeichnet, daß die Leuchtdiode auf der Grundfläche eines linsenförmig und nach oben gewölbten, rotationssymmetrischen Domes aus Epoxiharzmasse angeordnet ist, wobwi das Verhältnis von Durchmesser der Grundfläche zur höhe des Domes im Bereich von 0.5 bis 5. , vorzugsweise 1. bis 3.

3. Leuchtelement nach einem der Ansprüche 1 oder 2, dadurch gekennzeichnet, daß mehrere Leuchtdioden in jeweils einem Dom aus Epoxiharzmasse auf der Leiterplatte angeordnet sind.

4. Leuchtelement nach einem der Ansprüche 1 bis 3 , dadurch gekennzeichnet, daß das Epoxiharz ein hochwärmebeständiges, hochtransparentes Epoxiharz aus einer geeigneten Epoxikomponente und einer Anhydridgruppe enthaltenden Härterkomponente ist,das einen Brechungsindex im Bereich von 1,2 bis 1,7 aufweist.

5. Leuchtelement nach einem der Ansprüche 1 bis 4, dadurch gekennzeichnet, daß es entsprechend einer Glühlampe auswechselbar ist einem Gehäuse angeordnet ist.

6. Verfahren zur Herstellung eines Leuchtelementes nach einem der Ansprüche 1 bis 5, dadurch gekennzeichnet, daß wenigstens eine Leuchtdiode auf einer keramischen Leiterplatte mit Leiterbahnen nach dem Chip-und-Wire-Verfahren aufgebracht wird, daß dann ein Thixotropierungsmittel enthaltendes härtbares Epoxiharz auf die Leuchtdiode aufgebracht wird und daß am Schluß das Epoxiharz zuerst angehärtet und dann ausgehärtet wird.

7. Verfahren nach Anspruch 6,dadurch gekennzeichnet, daß das Thixotropierungsmittel in einer Menge von 2 bis 10 Gew.-% bezogen auf das Gesamtgewicht der Mischung aus Thixotropierungsmittel und Epoxiharz, mit dem Epoxiharz durch Rühren unter Unterdruck vermischt wird.

8. Verfahren nach Anspruch 6, dadurch gekennzeichnet, daß die Anhärtung in Anwesenheit eines geeigneten Trockenmittels bei einer Temperatur im Bereich von 25 bis 50 C° und über einen Zeitraum von 1 bis 100 Stunden durchgeführt wird.

9. Verfahren nach Anspruch 6, dadurch gekennzeichnet, daß das Epoxiharz bei einer Temperatur im Bereich von 70 bis 140 C° in einem Ofen ausgehärtet wird.

10. Verfahren nach Anspruch 6, dadurch gekennzeichnet, daß das Epoxiharz durch eine Kanüle von oben auf die Leuchtdiode aufextrudiert wird.



EP 0 315 905 A2

# Seitenansicht

3  6  2

1

4

7

9

8

# Figur 1

# Aufsicht

Figur 2